# EUROPEAN PATENT SPECIFICATION

(11) **EP 0 651 923 B1**
(45) Date of publication and mention of the grant of the patent: **29.04.1998**
(21) Application number: 93914765.8
(22) Date of filing: 08.07.1993
(51) Int. Cl.: H03L 7/06, H04J 3/06

(54) **A METHOD AND A DEVICE FOR GENERATING A CLOCK SIGNAL IN A MULTIPLEXING SYSTEM**
VERFAHREN UND VORRICHTUNG ZUR GENERIERUNG EINES TAKTSIGNALS IN EINEM MULTIPLEX-SYSTEM
METHODE ET DISPOSITIF DE GENERATION D'UN SIGNAL D'HORLOGE DANS UN SYSTEME MULTIPLEXEUR

(30) Priority: 21.07.1992 FI 923328
(43) Date of publication of application: 10.05.1995
(73) Proprietor: NOKIA TELECOMMUNICATIONS OY, 02150 Espoo (FI)
(72) Inventor: PELTOLA, Seppo, FIN-90570 Oulu (FI); RAAPPANA, Kari, FIN-90240 Oulu (FI); VÄHÄKANGAS, Juha, FIN-90240 Oulu (FI)
(74) Representative: Tomlinson, Kerry John
(86) International application number: FI9300293
(87) International publication number: WO9402994

(56) References cited:
- GB-A- 2 245 441
- GB-A- 2 249 004
- US-A- 4 521 891
- US-A- 4 987 373

## Description

The invention relates to a method according to the prior art portion of the attached claim 1 and a device according to the prior art portion of the attached claim 3 for generating a clock signal in a multiplexing system.

At present a clock signal of a multiplexing system is generated typically in such a way that the frequency of an incoming clock signal of a multiplexing unit is multiplied by means of a phase-locked loop by a number providing a clock frequency desired. For instance, when multiplexing 64 kbit/s channels into a basic 2,048 Mbit/s multiplexing system, the frequency (64 kHz) of an incoming clock signal of the multiplexing unit is multiplied by 32 in order to be able to generate a clock signal at a desired frequency for the multiplexing system, which signal is phase-locked to the incoming clock signal.

Because, however, the transmission devices sending the signals to be multiplexed are capable of transmitting data at very many different frequencies, it would be desirable to provide a method by means of which it is possible to generate a new clock signal phase-locked to the incoming clock signal, irrespective of the frequency of the incoming clock signal.

It is also generally known to use phase-locked loops as frequency synthetizers. A new output frequency is provided by loading a programmable divider in a feedback loop of the phase-locked loop with a new division factor. Due to the new division factor, the loop becomes unlocked and tries to lock to a new frequency, which is determined on the basis of the new division factor. Such PLL is known from GB-A-2 245 441. It would be conceivable to use such a solution known per se for achieving the above object as well. However, a drawback of the solution is that the accuracy of the new clock signal generated in this way is dependent on the selected incoming clock signal.

The object of the present invention is thus to achieve the aim described above in such a manner that the accuracy of the new clock signal remains unchanged irrespective of the selected incoming signal. This is achieved by means of the method of the invention, which is characterized in what is set forth in the characterizing portion of the attached claim 1. The device according to the invention is, in turn, characterized in what is set forth in the characterizing portion of claim 3.

The idea of the invention is to use a programmable divider at the input of a phase-locked loop (in addition to the fact that a fixed division factor is used at the feedback of the loop) in such a manner that the frequency of a signal to be applied to the phase-locked loop is always the same, irrespective of the clock frequency of the signal to which the phase is locked.

Thanks to the solution according to the invention, it is possible to generate from signals within an even very wide frequency range a signal phase-locked to these signals, the accuracy of the frequency of which signal is, as described above, independent on which signal is selected each time. Due to the solution of the invention, it is also possible to reduce the jitter of the generated phase-locked signal.

In the following the invention will be explained in more detail with reference to examples according to the attached drawing, in which
Figure 1 shows the operating environment of a method and a device according to the invention and
Figure 2 shows a device according to the invention to be applied to a multiplexing unit shown in Figure 1, in which device a clock signal is generated for a multiplexing system.

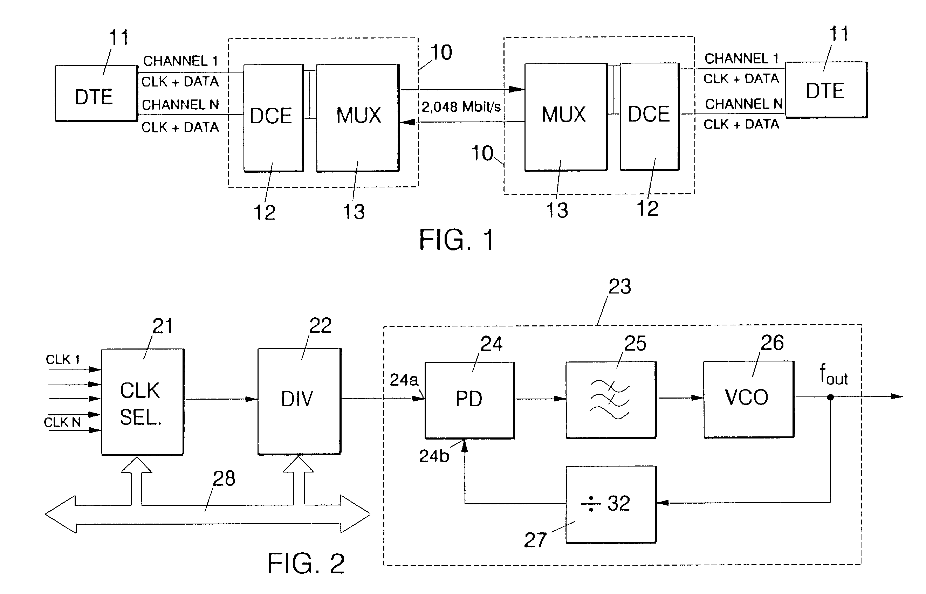

Figure 1 shows the operating environment of a method and a device according to the invention. By means of multiplexing units 10 known per se, a basic 2,048 Mbit/s multiplexing system is provided, which system transmits signals sent by or to one or several transmission devices 11, as e.g. a modem. A transmission device 11 can transmit or receive data at speeds typically in the range (1...31) x 64 kbit/s. The multiplexing unit 10 comprises an interface unit 12 receiving/sending the signals of the transmission devices and a multiplexer 13 connecting a multiplexed signal to a transmission path. The interface unit receives from the transmission device the actual data for each channel and a clock signal CLK of the channel in question, the frequency of which signal may be in the range (1...31) x 64 kHz, as per above. From one such clock signal is generated according to the invention an external clock signal for the multiplexing unit 10, with which signal a 2,048 Mbit/s transmission connection and the entire network can be synchronized. Said new clock signal is generated in a synchronization unit of the interface unit 12, to the input of which synchronization unit are brought the clock signals of the different channels.

Figure 2 shows the structure of said synchronization unit in more detail. Clock signals CLK 1... CLK N of channels entering the multiplexing unit, the frequencies of which signals may be in the range n x 64 kHz, are brought to a selector 21, which selects, under the control of a processor (not shown) controlling the device, the very clock signal selected by the user to be the signal from which a new clock signal for the multiplexing system is generated. The selector 21 is a multiplexer known per se. The selected clock signal is applied to a programmable divider 22 dividing the frequency of the clock signal by a division factor equal to the ratio of the frequency of said clock signal to the frequency 64 kHz. Over a bus 28 the processor provides a correct division factor depending on which clock signal has been selected each time.

Accordingly, the frequency of the output signal of the divider 22 is always 64 kHz, irrespective of which one of the clock signals CLK 1...CLK N has been selected each time. This signal is applied to a phase-locked loop 23, comprising in a manner known per se a phase comparator 24, the input 24a of which forms the input of the loop, a loop filter 25 of lowpass type, a voltage-controlled oscillator 26 and a divider 27 in a feedback line, which divider divides the output signal of the loop in this case by a fixed number 32. The output of the divider 27 is connected to a reference input 24b of the phase comparator. As known, the phase-locked loop acts as a frequency multiplier in such a way that the frequency of its output signal is equal to the frequency of the input signal of the loop multiplied by the division factor of the divider 27. Accordingly, the frequency fₒᵤₜ of the output signal is in this case 32 x 64 kHz = 2,048 MHz. The phase comparator 24 compares the phase of a 64 kHz signal to be applied to the comparator input with the phase of a reference signal generated from an outgoing 2,048 MHz signal by the divider 27. A pulse is generated at the output of the phase comparator, the length of which pulse is proportional to a phase error. This pulse is low pass filtered by the loop filter 25, which is a so-called lag lead filter known per se. The low pass filtered signal to be received from the output of the loop filter controls the frequency of the voltage-controlled oscillator 27 to be such that there is no phase difference between the signals applied to the inputs of the phase comparator. In this way, the outgoing 2,048 MHz signal is phase-locked to the clock signal selected by the selector 21 each time.

Since the frequency of the signal to be applied to the phase-locked loop is always the same, the phase-locked loop and especially the loop filter always operate in the same way. Due to this, the accuracy of the frequency of the output signal does not depend on the clock signal selected. The programmable divider 22 serves as an additional jitter filter as well, which partly reduces the jitter of the output signal.

Though the invention has above been described referring to the examples according to the attached drawings, it is clear that the invention is not restricted to that, but it may be modified in many ways within the scope of the inventive idea described above and in the attached claims. For instance, transmission devices of different types are possible and the desired output frequency may differ from the clock frequency of the basic multiplexing system presented above.

## Claims

1. A method of generating a clock signal in a multiplexing system, to which are applied several incoming signals, whereby the clock frequency of each signal may be a specific basic frequency or a multiple thereof, according to which method
- the clock frequency of one incoming signal is selected to be a source of a new clock frequency to be generated, and
- a second clock signal depending on the selected incoming signal is applied to a phase-locked loop (23) acting as a frequency multiplier, whereby the desired clock signal is generated by multiplying said second clock signal by means of the phase-locked loop by a desired multiplier, **characterized** in that said second clock signal is generated, in response to the selection made, by dividing (22) the clock signal corresponding to the selected incoming signal by a factor equal to the ratio of the clock frequency of the selected incoming signal to said basic frequency.

2. A method according to claim 1, **characterized** in that an external clock signal for a 2,048 Mbit/s basic multiplexing system is generated by means of this method by dividing the frequency of an external clock signal of one channel, before applying it to the phase-locked loop (23), by a factor which is equal to the ratio of the frequency of the clock signal of said channel to the frequency 64 kHz, said multiplier being 32.

3. A device for generating a clock signal in a multiplexing system, to which are applied several incoming signals, whereby the clock frequency of each signal may be a specific basic frequency or a multiple thereof, the device comprising a phase-locked loop (23), a feedback loop of the loop including a divider (27) with a fixed division factor, **characterized** in that it comprises:
- selecting means (21) for selecting a signal to be applied each time to the phase-locked loop (23) among several clock signals, whereby the frequency of each clock signal may be a specific basic frequency or a multiple thereof, and
- a frequency divider (22) responsive to the selecting means (21), the division factor of which divider is, in response to each selected signal, adjusted to be a factor equal to the ratio of the frequency of the selected clock signal to said basic frequency.

## Patentansprüche

1. Verfahren zum Erzeugen eines Taktsignals in einem Multiplexsystem, dem mehrere ankommende Signale zugeführt werden, wobei die Taktfrequenz jedes Signals eine spezifische Grundfrequenz oder ein Vielfaches davon sein kann, wobei gemäß diesem Verfahren
- die Taktfrequenz eines ankommenden Signals so gewählt wird, daß sie eine Quelle einer zu erzeugenden neuen Taktfrequenz ist, und
- ein zweites Taktsignal in Abhängigkeit von dem gewählten ankommenden Signal einem als Frequenzvervielfacher wirkenden Phasenregelkreis (23) zugeführt wird, wobei das gewünschte Taktsignal dadurch erzeugt wird, daß das zweite Taktsignal mittels des Phasenregelkreises mit einem gewünschten Multiplikator multipliziert wird,
dadurch gekennzeichnet,
daß das zweite Taktsignal in Abhängigkeit von der getroffenen Wahl dadurch erzeugt wird, daß das dem gewählten ankommenden Signal entsprechende Taktsignal durch einen Divisor dividiert (22) wird, der gleich dem Verhältnis zwischen der Taktfrequenz des gewählten ankommenden Signals und der Grundfrequenz ist.

2. Verfahren nach Anspruch 1,
dadurch gekennzeichnet,
daß ein externes Taktsignal für ein Grund-Multiplexsystem von 2048 Mbit/s mit Hilfe dieses Verfahrens erzeugt wird durch Division der Frequenz eines externen Taktsignals eines Kanals, bevor dieses dem Phasenregelkreis (23) zugeführt wird, durch einen Divisor, der gleich dem Verhältnis zwischen der Frequenz des Taktsignals dieses Kanals und der Frequenz von 64 kHz ist, wobei der Multiplikator 32 ist.

3. Vorrichtung zum Erzeugen eines Taktsignals in einem Multiplexsystem, dem mehrere ankommende Signale zugeführt werden, wobei die Taktfrequenz jedes Signals eine spezifische Grundfrequenz oder ein Vielfaches davon sein kann, wobei die Vorrichtung einen Phasenregelkreis (23) aufweist und wobei eine Rückkopplungsschleife des Phasenregelkreises einen Teiler (27) mit einem festgelegten Divisor besitzt,
dadurch gekennzeichnet,
daß die Vorrichtung folgendes aufweist:
- eine Wähleinheit (21), um unter mehreren Taktsignalen ein Signal zu wählen, das jedesmal an den Phasenregelkreis (23) anzulegen ist, wobei die Frequenz jedes Taktsignals eine spezifische Grundfrequenz oder ein Vielfaches davon sein kann, und
- einen auf die Wähleinheit (21) ansprechenden Frequenzteiler (22), dessen Divisor in Abhängigkeit von jedem gewählten Signal so eingestellt wird, daß er ein Divisor ist, der gleich dem Verhältnis zwischen der Frequenz des gewählten Taktsignals und der Grundfrequenz ist.

## Revendications

1. Procédé de génération d'un signal d'horloge dans un système multiplexeur auquel sont appliqués plusieurs signaux d'entrée, la fréquence d'horloge de chaque signal pouvant être une fréquence de base particulière ou un multiple de celle-ci, procédé selon lequel :
- la fréquence d'horloge d'un signal d'entrée est choisie pour servir de source pour une nouvelle fréquence d'horloge à engendrer, et
- un deuxième signal d'horloge, qui dépend du signal d'entrée choisi, est appliqué à une boucle à verrouillage de phase (23) qui agit en tant que multiplicateur de fréquence, le signal d'horloge requis étant engendré en multipliant le deuxième signal d'horloge au moyen de la boucle à verrouillage de phase par un multiplicateur choisi,
caractérisé en ce que le deuxième signal d'horloge est engendré, en réponse au choix effectué, en divisant (22) le signal d'horloge correspondant au signal d'entrée choisi, par un facteur égal au rapport entre la fréquence d'horloge du signal d'entrée choisi et la fréquence de base.

2. Procédé selon la revendication 1,
caractérisé en ce qu'un signal d'horloge externe pour un système multiplexeur de base de 2,048 Mbits/s est engendré au moyen de ce procédé, en divisant la fréquence d'un signal d'horloge externe d'une voie, avant de l'appliquer à la boucle verrouillée en phase (23), par un facteur égal au rapport entre la fréquence du signal d'horloge de ladite voie et la fréquence de 64 kHz, le multiplicateur étant égale à 32.

3. Dispositif pour engendrer un signal d'horloge dans un système multiplexeur auquel sont appliqués plusieurs signaux d'entrée, la fréquence d'horloge de chaque signal pouvant être une fréquence de base particulière ou un multiple de celle-ci, le dispositif comprenant une boucle à verrouillage de phase (23), une boucle de retour de la boucle comprenant un diviseur (27) à facteur de division fixe,
caractérisé en ce qu'il comprend :
- des moyens de sélection (21) pour sélectionner un signal qui doit être appliqué chaque fois à la boucle à verrouillage de phase (23) parmi plusieurs signaux d'horloge, la fréquence de chaque signal d'horloge pouvant être une fréquence de base particulière ou un multiple de celle-ci, et
- un diviseur de fréquence (22) réagisant aux moyens de sélection (21), le facteur de division étant ajusté en réponse à chaque signal sélectionné, pour être égal au rapport entre la fréquence du signal d'horloge sélectionné et la fréquence de base.
